# EUROPÄISCHE PATENTSCHRIFT

(11) **EP 3 013 838 B1**
(45) Veröffentlichungstag und Bekanntmachung des Hinweises auf die Patenterteilung: **10.05.2017**
(21) Anmeldenummer: 14726113.5
(22) Anmeldetag: 15.05.2014
(51) Int. Cl.: C07F 5/00, C23C 18/12, H01L 21/285

(54) **VERFAHREN ZUR HERSTELLUNG VON INDIUMALKOXID-VERBINDUNGEN, DIE NACH DEM VERFAHREN HERSTELLBAREN INDIUMALKOXID-VERBINDUNGEN UND IHRE VERWENDUNG**
METHOD FOR PRODUCING INDIUM ALKOXIDE COMPOUNDS, INDIUM ALKOXIDE COMPOUNDS PRODUCIBLE ACCORDING TO SAID METHOD AND THE USE THEREOF
PROCÉDÉ DE PREPARATION DE COMPOSES D'ALCOXYDE D'INDIUM, COMPOSES D'ALCOXYDE D'INDIUM POUVANT ETRE OBTENUS SELON CE PROCEDE ET LEUR UTILISATION

(30) Priorität: 25.06.2013 DE 102013212017
(43) Veröffentlichungstag der Anmeldung: 04.05.2016
(73) Patentinhaber: Evonik Degussa GmbH, 45128 Essen (DE)
(72) Erfinder: STEIGER, Jürgen, 111 Taipei City (TW); PHAM, Duy Vu, 46149 Oberhausen (DE); NEUMANN, Anita, 45657 Recklinghausen (DE); MERKULOV, Alexey, 45665 Recklinghausen (DE); HOPPE, Arne, 45136 Essen (DE); FRÜHLING, Dennis, 45768 Marl (DE)
(86) Internationale Anmeldenummer: PCT/EP2014/059957
(87) Internationale Veröffentlichungsnummer: WO 2014/206634

(56) Entgegenhaltungen:
- WO-A1-2011/072887
- DE-A1-102010 031 592

## Beschreibung

Die vorliegende Erfindung betrifft Verfahren zur Herstellung von Indiumalkoxid-Verbindungen, die nach dem Verfahren herstellbaren Indiumalkoxid-Verbindungen und ihre Verwendung.

Die Herstellung halbleitender elektronischer Bauteilschichten über Druck- und andere flüssige Abscheidungsprozesse ermöglicht im Vergleich zu vielen anderen Verfahren, wie z.B. Chemical Vapor Deposition (CVD), weitaus niedrigere Produktionskosten, da die Deposition des Halbleiters hier in einem kontinuierlichen Prozess erfolgen kann. Darüber hinaus eröffnet sich im Falle niedrigerer Prozesstemperaturen die Möglichkeit, auch auf flexiblen Substraten zu arbeiten, und gegebenenfalls (vor allem im Falle sehr dünner Schichten und insbesondere bei oxidischen Halbleitern) eine optische Transparenz der gedruckten Schichten zu erreichen. Unter halbleitenden Schichten sind hier und im folgenden Schichten zu verstehen, die Ladungsträgerbeweglichkeiten von 1 bis 50 cm²/Vs bei einem Bauteil mit einer Kanallänge von 20 µm bei 50 V Gate-Source-Spannung und 50 V Source-Drain-Spannung aufweisen.

Da das Material der über Druckverfahren herzustellenden Bauteilschicht die jeweiligen Schichteigenschaften maßgeblich bestimmt, hat seine Wahl einen bedeutsamen Einfluss auf jedes diese Bauteilschicht enthaltende Bauteil. Wichtige Parameter für gedruckte Halbleiterschichten sind ihre jeweiligen Ladungsträgerbeweglichkeiten sowie die Verarbeitbarkeiten und Verarbeitungstemperaturen der bei ihrer Herstellung eingesetzten verdruckbaren Vorstufen. Die Materialien sollten eine gute Ladungsträgerbeweglichkeit aufweisen und aus Lösung und bei Temperaturen deutlich unter 500 °C herstellbar sein, um für eine Vielzahl von Anwendungen und Substraten geeignet zu sein. Ebenfalls wünschenswert für viele neuartige Anwendungen ist eine optische Transparenz der erzeugten halbleitenden Schichten.

Indiumoxid (Indium(III)oxid, In₂O₃) ist aufgrund der großen Bandlücke zwischen 3.6 und 3.75 eV (gemessen für aufgedampfte Schichten, H.S. Kim, P.D. Byrne, A. Facchetti, T.J. Marks; J. Am. Chem. Soc. 2008, 130, 12580-12581) ein vielversprechender und somit gerne eingesetzter Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 cm²/Vs messen. Bislang können jedoch solche Werte durch Prozessierung aus Lösung noch nicht erreicht werden (H. Nakazawa, Y. Ito, E. Matsumoto, K. Adachi, N. Aoki, Y. Ochiai; J. Appl. Phys. 2006, 100, 093706. und A. Gupta, H. Cao, Parekh, K.K.V. Rao, A.R. Raju, U.V. Waghmare; J. Appl. Phys. 2007, 101, 09N513).

Indiumoxid wird oft vor allem zusammen mit Zinn(IV)-oxid (SnO₂) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Aufgrund des großen wirtschaftlichen Interesses an ITO-beschichteten Substraten existieren mittlerweile einige, vor allem auf Sol-Gel-Techniken beruhende Beschichtungsverfahren für Indiumoxidhaltige Schichten.

Prinzipiell gibt es zwei Möglichkeiten für die Herstellung von Indiumoxid-Halbleitern über Druckverfahren: 1) Partikel-Konzepte, bei denen (Nano)Partikel in verdruckbarer Dispersion vorliegen und nach dem Druckvorgang durch Sintervorgänge in die gewünschte Halbleiterschicht konvertiert werden, sowie 2) Precursor-Konzepte, bei denen mindestens ein lösliches oder dispergierbares Vorprodukt nach dem Verdrucken einer entsprechenden Zusammensetzung zu einer Indiumoxid-haltigen Schicht umgesetzt wird. Das Partikelkonzept hat zwei bedeutende Nachteile gegenüber dem Einsatz von Precursoren: Zum einen weisen die Partikel-Dispersionen eine kolloidale Instabilität auf, die die Anwendung von (in Bezug auf die späteren Schichteigenschaften nachteiligen) Dispergieradditiven erforderlich macht, zum anderen bilden viele der einsetzbaren Partikel (z.B. aufgrund von Passivierungsschichten) nur unvollständig Schichten durch Sinterung aus, so dass in den Schichten teilweise noch partikuläre Strukturen vorkommen. An deren Partikelgrenze kommt es zu einem erheblichen Partikel-Partikel-Widerstand, welcher die Beweglichkeit der Ladungsträger verringert und den allgemeinen Schichtwiderstand erhöht.

Es gibt verschiedene Precursoren für die Herstellung von Indiumoxid-Schichten. So können neben Indiumsalzen Indium-Alkoxide (homoleptische, d.h. nur Indium und Alkoxid-Reste aufweisende Verbindungen) als Precursoren für die Herstellung von Indiumoxid-haltigen Schichten eingesetzt werden.

Zum Beispiel beschreiben Marks et al. Bauteile, bei deren Herstellung eine Precursor-haltige Zusammensetzung umfassend das Salz InCl₃ sowie der Base Monoethanolamin (MEA) gelöst in Methoxyethanol eingesetzt wird. Nach Aufschleudern (Spin-coating) der Zusammensetzung wird die entsprechende Indiumoxid-Schicht durch eine thermische Behandlung bei 400 °C erzeugt (H.S. Kim, P.D. Byrne, A. Facchetti, T.J. Marks; J. Am. Chem. Soc. 2008, 130, 12580-12581 and supplemental informations).

WO 2011/072887 A1 beschreibt ein Verfahren zur Herstellung von Indium(III)halogendialkoxiden und deren Verwendung zur Herstellung Indiumoxid-haltiger Schichten. Verfahren zur Herstellung Indiumoxid-haltiger Schichten aus diesen Indium(III)halogendialkoxiden werden in WO 2011/073005 A2 offenbart.

Indium(III)halogendialkoxide führen jedoch bislang nicht zu Indiumoxid-haltigen Schichten mit hinreichend guten elektrischen Eigenschaften. Zu besseren Schichteigenschaften führen Indiumoxoalkoxide, wie zum Beispiel die in WO 2012/010427 A1, WO 2012/010464 A1 und in der bislang nicht offen gelegten deutschen Anmeldung DE 10 2012 209918 offenbarten Verbindungen der generischen Formeln In₆O₂X₆(OR)₆(R'CH(O)COOR")₂(HOR)ₓ(HNR'"₂)_{y}, In₇O₂(OH)(OR)₁₂X₄(ROH)ₓsowie MₓO_{y}(OR)_{z}[O(R'O)ₑH]ₐX_{b}Y_{c}[R"OH]_{d}.

Trotz der bereits bekannten Verbesserungen besteht ein beständiger Bedarf an Verbesserungen hinsichtlich der Schichtbildungseigenschaften und der Eigenschaften der erhaltenen Schichten. Insbesondere soll ein geeigneter Precursor sich
- gut, insbesondere an Luft, verarbeiten lassen,
- homogen in das Oxid umwandeln,
- bei möglichst niedrigen Temperaturen in das Oxid umwandeln lassen und
- zu Schichten mit herausragenden elektrischen Eigenschaften führen.

Dieses komplexe Anforderungsprofil wird durch eine Indiumalkoxid-Verbindung erfüllt, die herstellbar ist durch Umsetzen
- eines Indiumtrihalogenids InX₃ mit X = F, Cl, Br, I
- mit einem sekundären Amin der Formel R'₂NH mit R` =Alkyl,
   ∘ im molaren Verhältnis von 8:1 bis 20:1 in Bezug auf das Indiumtrihalogenid
- in Gegenwart eines Alkohols der generischen Formel ROH mit R = Alkyl.

Besonders gute Schichten lassen sich mit Indiumalkoxid-Verbindungen herstellen, bei denen das sekundäre Amin bei der Umsetzung in einem molaren Verhältnis von 8:1 bis 15:1, noch besser in einem Verhältnis von 8:1 bis 12:1 in Bezug auf das Indiumtrihalogenid eingesetzt wird.

Unter einer Indiumalkoxid-Verbindung im Sinne der vorliegenden Erfindung ist vorliegend eine mindestens ein Indiumatom und mindestens einen Alkoxid-Rest aufweisende Verbindung zu verstehen, die über die beschriebene Umsetzung des Trihalogenids mit dem sekundären Amin in Gegenwart eines Alkohols hergestellt werden kann. Die Bestimmung der Struktur dieser nach dem erfindungsgemäßen Verfahren erhältlichen gelösten Verbindungen ist schwierig. Es wird jedoch angenommen, dass die resultierenden Verbindungen halogenhaltige Indiumoxoalkoxid-Verbindungen sind. Entsprechende Festkörperstrukturen konnten über Röntgenstrukturanalysen ermittelt werden. Es wird angenommen, dass ähnliche Strukturen für diese Verbindungen auch in Lösung vorliegen. Bei Indiumoxoalkoxiden handelt es sich um ggf. in ionischer Form vorliegende, über Oxo-Reste verbrückte Indiumcluster, bei denen nicht mit Oxo-Resten koordinierte Valenzen zumindest zum Teil mit Alkoxidresten koordiniert sind. Für die nach dem erfindungsgemäßen Verfahren erhältlichen Indiumalkoxid-Verbindungen wird angenommen, dass diese nach der Synthese üblicherweise als Salz vorliegen, insbesondere als mit Kationen koordinierte halogenhaltige Indiumoxoalkoxid-Anionen.

Eine besonders bevorzugtes Verfahrensprodukt ist eine Indiumalkoxid-Verbindung der generischen Formel [In₆(O)(OR)₁₂X₆]²⁻Aₘ^{z} (ROH)ₓ mit R = Alkyl, X = F, Cl, Br, I, A = Kation, z = Wertigkeit des Kations, m·z = 2 und x = 0 bis 10, das sich u.a. bei Verwendung sekundärer Amine im Verhältnis von 9:1 bis 10:1 herstellen lässt. Die Verbindung kann mit Alkoholmolekülen ROH und ggf. auch mit anderen bei der Reaktion anwesenden Solventien koordiniert sein.

Typische Kationen sind Ammoniumionen [NH_{y}R_{4-y}]⁺, bevorzugt Ammoniumionen der Formel [NH₂R₂]⁺.

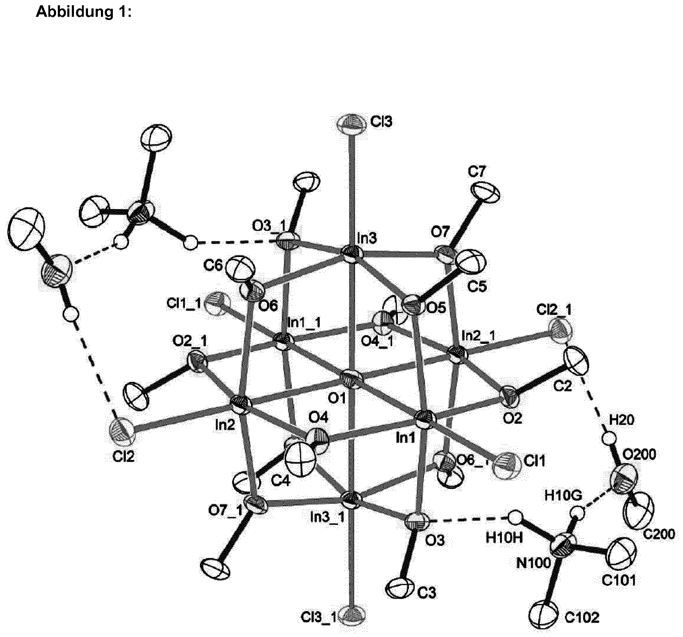

Eine ganz besonders bevorzugte Verbindung ist [In₆(O)(OMe)₁₂Cl₆]²⁻[NH₂R₂]⁺₂ (MeOH)₂, die durch Verwendung von InCl₃, Me₂NH (letzteres im Verhältnis von 9:1 bis 10:1) und MeOH (Methanol) hergestellt werden kann. Ihre über Röntgenstrukturanalyse ermittelte Struktur ist in Abbildung 1 dargestellt.

Gegenstand der vorliegenden Erfindung ist weiterhin ein Verfahren zur Herstellung von Indiumalkoxid-Verbindungen, bei dem
- ein Indiumtrihalogenid InX₃ mit X = F, Cl, Br, I
- mit einem sekundären Amin der Formel R'₂NH mit R' =Alkyl,
   ∘ im molaren Verhältnis von 8:1 bis 20:1 in Bezug auf das Indiumtrihalogenid
- in Gegenwart eines Alkohols der generischen Formel ROH mit R = Alkyl umgesetzt wird.

Indiumtrihalogenide der Formel InX₃ sind dem Fachmann bekannt und können käuflich erworben werden.

Sekundäre Amine der Formel R'₂NH mit R' =Alkyl gehören ebenfalls zum Stand der Technik. Bevorzugt handelt es sich bei dem Alkylrest R' um einen linearen, verzweigten oder cyclischen C₁- bis C₁₀-Alkylrest der Formel CₙH₂ₙ₊₁ mit n = 1 bis 10. Zwei Reste R' eines oder zweier verschiedener sekundärer Amine können auch gemeinsam einen Alkylenrest CₙH₂ₙ bilden. Entsprechend einsetzbare Verbindungen sind z.B. Dimethylamin, Diethylamin, Dipropylamin, Pyrrolidin, Piperidin und Pyrrol. Bevorzugte Reste R' sind die Reste Methyl, Ethyl, n-Propyl und i-Propyl. Ganz bevorzugt ist der Rest R' Methyl, da dies zu besonders guten Ausbeuten und besonders stabilen Verbindungen führt.

Als Alkohol ROH werden bevorzugt solche mit linearen, verzweigten oder cyclischen C₁- bis C₁₀-Alkylresten der Formel CₙH₂ₙ₊₁ mit n = 1 bis 10 eingesetzt. Bevorzugte Reste R sind auch hier Methyl, Ethyl, n-Propyl und i-Propyl. Ganz bevorzugt sind die Reste R Methyl.

Das Indiumtrihalogenid wird bevorzugt in Anteilen von 0,1 bis 50 Gew.-%, besonders bevorzugt 1 bis 25 Gew.-%, ganz besonders bevorzugt 2 bis 10 Gew.-% bezogen auf die Gesamtmasse aller Komponenten eingesetzt.

Das Indiumtrihalogenid kann gelöst, d.h. dissoziiert bzw. auf molekularer Ebene komplexiert mit Lösemittelmolekülen/Alkoholmolekülen, oder in flüssiger Phase dispergiert werden.

Der Alkohol ROH wird bevorzugt in Anteilen von 50 bis 99,9 Gew.-%, besonders bevorzugt 75 bis 99 Gew.-%, ganz besonders bevorzugt 80 bis 96 Gew.-% bezogen auf die Gesamtmasse aller Komponenten eingesetzt.

Das Reaktionsgemisch kann weiterhin mindestens ein in Bezug auf die Reaktion inertes flüssiges Lösemittel bzw. Dispersionsmedium, d.h. ein Lösemittel/Dispersionsmedium oder ein Gemisch verschiedener Lösemittel/Dispersionsmedien, die unter den Reaktionsbedingungen nicht mit den Indiumtrihalogeniden reagieren, aufweisen. Vorzugsweise einsetzbar sind aprotische Lösemittel, insbesondere solche ausgewählt aus der Gruppe der aprotischen unpolaren Lösemittel, d.h. der Alkane, substituierten Alkane, Alkene, Alkine, Aromaten ohne oder mit aliphatischen oder aromatischen Substituenten, halogenierten Kohlenwasserstoffe und Tetramethylsilan, und der Gruppe der aprotischen polaren Lösemittel, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat.

Liegt mindestens ein solches in Bezug auf die Reaktion inertes flüssiges Lösemittel bzw. Dispersionsmedium in dem Reaktionsgemisch vor, beträgt sein Anteil bevorzugt 1 bis 50 Gew.-%, besonders bevorzugt 1 bis 25 Gew.-%, ganz besonders bevorzugt 1 bis 10 Gew.-% bezogen auf die Gesamtmasse aller Komponenten.

Bevorzugt wird das sekundäre Amin bei der Umsetzung in einem molaren Verhältnis von 8:1 bis 15:1, noch besser in einem Verhältnis von 8:1 bis 12:1 in Bezug auf das Indiumtrihalogenid eingesetzt, weil dann in besonders hoher Ausbeute besonders gut für die Schichtherstellung geeignete Indiumalkoxid-Verbindungen hergestellt werden können.

Bevorzugt wird das erfindungsgemäße Verfahren so durchgeführt, dass Indiumtrihalogenid in Alkohol ROH vorgelegt wird. Das sekundäre Amin wird gasförmig, flüssig oder in Lösemittel gelöst (umfassend insbesondere ROH als Lösemittel) zugegeben.

Ebenfalls bevorzugt erfolgt die Zugabe bei SATP-Bedingungen (25 °C und 1,013 bar).

Da die Reaktion so besonders gut steuerbar ist und zu besonders guten Indiumalkoxid-Verbindungen führt, wird das Dialkylamin bevorzugt mit einer Geschwindigkeit von 0,5 bis 5 Mol pro Stunde und Mol Indiumhalogenid, bevorzugt 1,15 bis 2,60 Mol pro Stunde und Mol Indiumhalogenid zugegeben.

Weiter bevorzugt wird das Reaktionsgemisch nach Zugabe aller Komponenten erwärmt. Bevorzugt wird das Reaktionsgemisch über eine Zeit von 1 bis 10 h auf eine Temperatur zwischen 40 und 70 °C erwärmt. Weiter bevorzugt wird das Reaktionsgemisch über eine Zeit von 1 bis 5 h auf eine Temperatur zwischen 45 und 60 °C erwärmt. Danach wird das Reaktionsgemisch abgekühlt.

Nach Beendigung der Reaktion wird das Produkt bzw. Produktgemisch, das üblicherweise ausfällt, bevorzugt von den übrigen Bestandteilen der Reaktionszusammensetzung separiert. Bevorzugt erfolgt dies über Filtration. Bevorzugt wird das separierte Produktgemisch weiterhin mit geeigneten Lösemitteln getrocknet und gewaschen.

Besonders gute Indiumalkoxid-Verbindungen resultieren, wenn das erhaltene Produkt bzw. das erhaltene Produktgemisch nach Separation und ggf. erfolgter Trocknung und/oder Waschung rekristallisiert wird. Bevorzugt wird die Rekristallisation in dem Alkohol ROH durchgeführt, der auch bei der Synthese der Verbindung eingesetzt wurde. Bevorzugt wird die Rekristallisation so durchgeführt, das das isolierte Produkt bzw. Produktgemisch in siedendem Alkohol gelöst und anschließend bei Temperaturen von -30 bis 0 °C auskristallisiert wird. Das überstehende Lösemittel wird verworfen und das kristalline Produkt kann für die weitere Verwendung eingesetzt werden.

Die erfindungsgemäße Verbindung eignet sich besonders vorteilhaft zur Herstellung Indiumoxid-haltiger Beschichtungen mit verbesserten elektrischen Eigenschaften, insbesondere über nasschemische Verfahren. Diese Verbesserung ist insofern überraschend, da man für Precursoren von Metalloxiden im Allgemeinen nach Substanzen sucht, die über eine möglichst geringe Kristallisationsneigung verfügen. Die erfindungsgemäßen Verbindungen stellen jedoch vielfach Clusterverbindungen dar, die somit schon eine Mikrokristallitstruktur aufweisen. Die gewünschte Metalloxidschicht sollte auch eher einen amorphen als einen kristallinen Charakter aufweisen, um über besonders gute elektrische Eigenschaften zu verfügen. Entgegen der Erwartung können mit der erfindungsgemäßen Verbindung Schichten hergestellt werden, die besonders homogen sind.

Unter Indiumoxid-haltigen Beschichtungen sind in diesem Falle sowohl Indiumoxid-Schichten als auch Schichten im Wesentlichen umfassend Indiumoxid und weitere Metalle und/oder Metalloxide zu verstehen. Unter einer Indiumoxid-Schicht im Sinne der vorliegenden Erfindung ist dabei eine aus den erwähnten Indiumalkoxiden herstellbare, metallhaltige Schicht zu verstehen, die im Wesentlichen Indiumatome bzw. -ionen aufweist, wobei die Indiumatome bzw. -ionen im Wesentlichen oxidisch vorliegen. Gegebenenfalls kann die Indiumoxid-Schicht auch noch Halogen- bzw. Alkoxid-Anteile aus einer nicht vollständigen Konvertierung und/oder Stickstoff, Wasserstoff und/oder Kohlenstoff aufweisen. Entsprechendes gilt auch für Schichten im Wesentlichen umfassend Indiumoxid und weitere Metalle und/oder Metalloxide, mit der Maßgabe, dass diese weiterhin die weiteren Metalle und/oder Metalloxide aufweist.

Die erfindungsgemäße Verbindung hat weiterhin den überraschenden Vorteil, dass diese besonders gut für die Herstellung leitender oder halbleitender Indiumoxid-haltiger Schichten für elektronische Bauteile, insbesondere zur Herstellung von (Dünnschicht)Transistoren, Dioden oder Solarzellen, eingesetzt werden kann.

Die nachfolgenden Beispiele sollen den Gegenstand der vorliegenden Erfindung weiter erläutern, ohne selbst beschränkend zu wirken.

### Erfindungsgemäßes Beispiel

### Synthese

In einem von Restfeuchte befreiten 30L Reaktor werden 1.30 kg

Indium(III)-chlorid (InCl₃, 5.9 mol) unter Schutzgasatmosphäre durch Rühren in 17.38 kg getrocknetem Methanol suspendiert. Dimethylamin (2.57 kg, 57 mol) wird über einen Massflow-Controller (0.86 kg/h, ca. 4 h) bei Raumtemperatur zudosiert, wobei eine leicht exotherme Reaktion beobachtet werden kann. Danach wird das Reaktionsgemisch 2 h lang bei 50°C temperiert, bis zu der Raumtemperatur abgekühlt und filtriert. Der Filterrückstand wird mit 4x500 mL getrocknetem Methanol gewaschen und 8h lang am Vakuum (0.1 mbar) getrocknet. Das Material wird in siedendem Methanol gelöst und bei -20°C auskristallisiert.

### Herstellung einer Formulierung

Der erhaltene Stoff wird mit einer Konzentration von 50 mg/mL in 1-Methoxy-2-propanol gelöst. Das erhaltende Konzentrat wird folgendermaßen formuliert: 1 Teil Konzentrat zu 2 Teilen 1-Methoxy-2-propanol zu einem Teil Ethanol. Dieser Formulierung werden weitere 3 Gew.-% Tetrahydrofurfurylalkohol (THFA) zugegeben. Alle verwendeten Lösungsmittel sind wasserfrei (<200 ppm H₂O) und das Mischen erfolgt unter inerten Bedingungen (ebenfalls wasserfrei). Die erhaltene Formulierung wird final durch einen 200 nm PTFE-Filter gefiltert.

### Beschichtung

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 µl der oben genannten Formulierung benetzt. Dann erfolgt Spin Coating bei 2000 rpm (30 Sekunden). Das beschichtete Substrat wird direkt nach diesem Beschichtungsvorgang für 10 Minuten mit aus einer Quecksilberdampflampe stammenden UV-Strahlung im Wellenlängenbereich von 150 - 300 nm bestrahlt. Anschließend wird das Substrat eine Stunde auf einer Heizplatte bei einer Temperatur von 350°C erhitzt. Nach der Konvertierung lässt sich in der Glove Box ein Wert für die Feldeffektbeweglichkeit (im linearen Bereich) µFET = 14 cm²/Vs bei 2 VDS bestimmen.

### Vergleichsbeispiel

### Synthese

In einem von Restfeuchte befreiten 500 ml-Glasrundkolben werden 5,0 g Indium(III)-chlorid (InCl₃, 22,5 mmol) unter Schutzgasatmosphäre durch Rühren in 250 ml getrocknetem Methanol gelöst, wobei ein Rückstand an InCl₃ von < 10 Gew.-% (bzgl. der Einwaage) zurückbleibt. Die Dosierung der Base Dimethylamin (5,0 g entsprechend 111 mmol) wird über einen Massflow-Controller sichergestellt und in der stöchiometrischen Menge bzgl. InCl₃ bei Raumtemperatur über einen Zeitraum von fünf Stunden zugegeben, wobei eine leicht exotherme Reaktion am Anfang beobachtet wurde. Anschließend wird die Lösung vollständig verdampft, der zurückbleibende Feststoff mit 250 ml getrocknetem Methanol aufgenommen, unter Schutzgas (N₂) filtriert, mehrfach (10 Vorgänge) mit getrocknetem Methanol gewaschen und unter Vakuum (< 10 mbar) für 12 h bei Raumtemperatur getrocknet. Die Produktausbeute betrug > 80 mol-% an Indium(III)chlordimethoxid.

### Herstellen einer Formulierung

Der erhaltene Stoff wird mit einer Konzentration von 50 mg/mL in 1-Methoxy-2-propanol gelöst. Das erhaltende Konzentrat wird folgendermaßen formuliert: 1 Teil Konzentrat zu 2 Teilen 1-Methoxy-2-propanol zu einem Teil Ethanol. Dieser Formulierung werden weitere 3 Gew.-% Tetrahydrofurfurylalkohol (THFA) zugegeben. Alle verwendeten Lösungsmittel sind wasserfrei (<200 ppm H₂O) und das Mischen erfolgt unter inerten Bedingungen (ebenfalls wasserfrei). Die erhaltene Formulierung wird final durch einen 200 nm PTFE-Filter gefiltert.

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 µl der oben genannten Formulierung benetzt. Dann erfolgt Spin Coating bei 2000 rpm (30 Sekunden). Das beschichtete Substrat wird direkt nach diesem Beschichtungsvorgang für 10 Minuten mit aus einer Quecksilberdampflampe stammender UV-Strahlung im Wellenlängenbereich von 150 - 300 nm bestrahlt. Anschließend wird das Substrat eine Stunde auf einer Heizplatte bei einer Temperatur von 350°C erhitzt. Nach der Konvertierung lässt sich in der Glove Box ein Wert für die Feldeffektbeweglichkeit (im linearen Bereich) µFET = 8 cm²/Vs bei 2 VDS bestimmen.

## Patentansprüche

1. Indiumalkoxid-Verbindung,
herstellbar durch Umsetzen
- eines Indiumtrihalogenids InX₃ mit X = F, Cl, Br, I
- mit einem sekundären Amin der Formel R'₂NH mit R' =Alkyl,
∘ im molaren Verhältnis von 8:1 bis 20:1 in Bezug auf das Indiumtrihalogenid
- in Gegenwart eines Alkohols der generischen Formel ROH mit R = Alkyl.

2. Indiumalkoxid-Verbindung nach Anspruch 1, **dadurch gekennzeichnet, dass** sie herstellbar ist durch ein Verfahren, bei dem das sekundäre Amin im molaren Verhältnis von 8:1 bis 15:1, bevorzugt 8:1 bis 12:1 in Bezug auf das Indiumtrihalogenid vorliegt.

3. Verbindung der generischen Formel
[ln₆(O)(OR)₁₂X₆]²⁻Aₘ² (ROH)ₓ
mit R = Alkyl, X = F, Cl, Br, I, A = Kation, z = Wertigkeit des Kations, m·z = 2 und x = 0 bis 10.

4. Verbindung nach Anspruch 3, **dadurch gekennzeichnet, dass** sie die generische Formel [ln₆(O)(OMe)₁₂Cl_{6]}²⁻[NH₂R₂]⁺₂ (MeOH)₂ hat.

5. Verfahren zur Herstellung von Indiumalkoxid-Verbindungen, bei dem
- ein Indiumtrihalogenid InX₃ mit X = F, Cl, Br, I
- mit einem sekundären Amin der Formel R'₂NH mit R' =Alkyl,
- im molaren Verhältnis von 8:1 bis 20:1 in Bezug auf das Indiumtrihalogenid
- in Gegenwart eines Alkohols der generischen Formel ROH mit R = Alkyl umgesetzt wird.

6. Verfahren nach Anspruch 5, **dadurch gekennzeichnet, dass** das molare Verhältnis von 8:1 bis 15:1, bevorzugt 8:1 bis 12:1 beträgt.

7. Verfahren nach Anspruch 6, **dadurch gekennzeichnet, dass** das Indiumtrihalogenid in Alkohol ROH vorgelegt wird und das sekundäre Amin gasförmig, flüssig oder in Lösemittel gelöst zugegeben wird.

8. Verfahren nach Anspruch 7, **dadurch gekennzeichnet, dass** das Dialkylamin mit einer Geschwindigkeit von 0,5 bis 5 Mol pro Stunde und Mol InX₃ zugegeben wird.

9. Verfahren nach einem der Ansprüche 5 bis 8, **dadurch gekennzeichnet, dass** das Reaktionsgemisch nach Zugabe aller Komponenten über eine Zeit von 1 bis 10 h auf eine Temperatur zwischen 40 und 70 °C erwärmt wird.

10. Verfahren nach einem oder mehreren der Ansprüche 5 bis 9, **dadurch gekennzeichnet**, das die entstehende Indiumalkoxid-Verbindung von den übrigen Bestandteilen der Reaktionszusammensetzung separiert und rekristallisiert wird.

11. Verwendung einer Verbindung nach einem der Ansprüche 1 bis 4 oder eines Produktes nach einem Verfahren nach einem der Ansprüche 5 bis 10 zur Herstellung Indiumoxid-haltiger Beschichtungen.

12. Verwendung einer Verbindung nach einem der Ansprüche 1 bis 4 oder eines Produktes nach einem Verfahren nach einem der Ansprüche 5 bis 10 für die Herstellung halbleitender oder leitender Schichten für elektronische Bauteile, insbesondere zur Herstellung von (Dünnschicht)Transistoren, Dioden oder Solarzellen.

## Claims

1. Indium alkoxide compound
preparable by reacting
- an indium trihalide InX₃ where X = F, Cl, Br, I
- with a secondary amine of the formula R'₂NH where R' = alkyl,
∘ in a molar ratio of 8:1 to 20:1 in relation to the indium trihalide,
- in the presence of an alcohol of the generic formula ROH where R = alkyl.

2. Indium alkoxide compound according to Claim 1, **characterized in that** it is preparable by a process in which the secondary amine is present in a molar ratio of 8:1 to 15:1, preferably 8:1 to 12:1, in relation to the indium trihalide.

3. Compound of the generic formula
[In₆(O)(OR)₁₂X₆]²-Aₘ² (ROH)ₓ
where R = alkyl, X = F, Cl, Br, I, A = cation, z = valency of the cation, m·z = 2 and x = 0 to 10.

4. Compound according to Claim 3, **characterized in that** it has the generic formula [In₆(O)(OMe)₁₂C₁₆]²⁻[NH₂R₂]⁺₂ (MeOH)₂.

5. Process for preparing indium alkoxide compounds, in which
- an indium trihalide InX₃ where X = F, Cl, Br, I
- is reacted with a secondary amine of the formula R'₂NH where R' = alkyl,
- in a molar ratio of 8:1 to 20:1 in relation to the indium trihalide,
- in the presence of an alcohol of the generic formula ROH where R = alkyl.

6. Process according to Claim 5, **characterized in that** the molar ratio is from 8:1 to 15:1, preferably 8:1 to 12:1.

7. Process according to Claim 6, **characterized in that** the indium trihalide is initially charged in alcohol ROH and the secondary amine is added in gaseous form, in liquid form or dissolved in solvent.

8. Process according to Claim 7, **characterized in that** the dialkylamine is added at a rate of 0.5 to 5 mol per hour and mole of InX₃.

9. Process according to any of Claims 5 to 8, **characterized in that** the reaction mixture, after addition of all the components, is heated to a temperature between 40 and 70°C over a period of 1 to 10 h.

10. Process according to one or more of Claims 5 to 9, **characterized in that** the indium alkoxide compound formed is separated from the other constituents of the reaction composition and recrystallized.

11. Use of a compound according to any of Claims 1 to 4 or of a product according to a process according to any of Claims 5 to 10 for production of indium oxide-containing coatings.

12. Use of a compound according to any of Claims 1 to 4 or of a product according to a process according to any of Claims 5 to 10 for the production of semiconductive or conductive layers for electronic components, especially for production of (thin-film) transistors, diodes or solar cells.

## Revendications

1. Composé d'alcoxyde d'indium, pouvant être fabriqué par mise en réaction
- d'un trihalogénure d'indium InX₃ avec X = F, Cl, Br, I
- avec une amine secondaire de formule R'₂NH avec R' = alkyle,
- en un rapport molaire de 8:1 à 20:1 par rapport au trihalogénure d'indium,
- en présence d'un alcool de formule générique ROH avec R = alkyle.

2. Composé d'alcoxyde d'indium selon la revendication 1, **caractérisé en ce qu'**il peut être fabriqué par un procédé selon lequel l'amine secondaire est présente en un rapport molaire de 8:1 à 15:1, de préférence de 8:1 à 12:1, par rapport au trihalogénure d'indium.

3. Composé de formule générique
[In₆(O)(OR)₁₂X₆]²⁻Aₘ^{z}(ROH)ₓ
avec R = alkyle, X = F, Cl, Br, I, A = cation, z = valence du cation, m·z = 2 et x = 0 à 10.

4. Composé selon la revendication 3, **caractérisé en ce qu'**il a la formule générique [In₆(O)(OMe)₁₂Cl₆]²⁻ [NH₂R₂]⁺₂ (MeOH)₂.

5. Procédé de fabrication de composés d'alcoxyde d'indium, selon lequel
- un trihalogénure d'indium InX₃ avec X = F, Cl, Br, I est mis en réaction
- avec une amine secondaire de formule R'₂NH avec R' = alkyle,
- en un rapport molaire de 8:1 à 20:1 par rapport au trihalogénure d'indium,
- en présence d'un alcool de formule générique ROH avec R = alkyle.

6. Procédé selon la revendication 5, **caractérisé en ce que** le rapport molaire est de 8:1 à 15:1, de préférence de 8:1 à 12:1.

7. Procédé selon la revendication 6, **caractérisé en ce que** le trihalogénure d'indium est chargé initialement dans l'alcool ROH et l'amine secondaire est ajoutée sous forme gazeuse, liquide ou dissoute dans un solvant.

8. Procédé selon la revendication 7, **caractérisé en ce que** la dialkylamine est ajoutée à une vitesse de 0,5 à 5 moles par heure et mole d'InX₃.

9. Procédé selon l'une quelconque des revendications 5 à 8, **caractérisé en ce que** le mélange réactionnel est porté à une température comprise entre 40 et 70 °C après l'ajout de tous les composants pendant une durée de 1 à 10 h.

10. Procédé selon une ou plusieurs des revendications 5 à 9, **caractérisé en ce que** le composé d'alcoxyde d'indium formé est séparé des autres constituants de la composition réactionnelle et recristallisé.

11. Utilisation d'un composé selon l'une quelconque des revendications 1 à 4 ou d'un produit d'un procédé selon l'une quelconque des revendications 5 à 10 pour la fabrication de revêtements contenant de l'oxyde d'indium.

12. Utilisation d'un composé selon l'une quelconque des revendications 1 à 4 ou d'un produit d'un procédé selon l'une quelconque des revendications 5 à 10 pour la fabrication de couches semi-conductrices ou conductrices pour composants électroniques, notamment pour la fabrication de transistors (à couche mince), de diodes ou de cellules solaires.
